# EUROPEAN PATENT SPECIFICATION

(11) **EP 2 485 321 B1**
(45) Date of publication and mention of the grant of the patent: **19.10.2016**
(21) Application number: 11153344.4
(22) Date of filing: 04.02.2011
(51) Int. Cl.: H01R 13/66, H01R 13/533, H05K 7/20, F04B 43/04

(54) **Electrical connector comprising a temperature control arrangement**
Elektrischer Stecker mit einer Temperatursteuerungsanordnung
Connecteur électrique comprenant un dispositif de contrôle de la température

(43) Date of publication of application: 08.08.2012
(73) Proprietor: Sony Ericsson Mobile Communications AB, 221 88 Lund (SE)
(72) Inventor: KLINGHULT, Gunnar, 223 59, Lund (SE)
(74) Representative: Awapatent AB

(56) References cited:
- EP-A1- 2 023 461
- EP-A1- 2 104 183
- EP-A1- 2 267 870
- US-A- 2 776 385
- US-A1- 2006 236 710
- US-A1- 2009 167 109
- US-A1- 2009 206 699
- US-A1- 2009 256 523
- US-B1- 6 801 430

## Description

### TECHNICAL FIELD

The invention relates to devices for protection against heating, e.g. during battery charging of an electrical device such as a mobile telephone, e.g. in order to improve the charging degree of the terminal.

### BACKGROUND

It is known that mobile devices, such as mobile telephones need batteries or accumulators to store electrical energy to keep them in operation-ready status, and that these are therefore implemented directly in the device. It is also known that these batteries are being designed with progressively small dimensions, in order to fit into the mobile device, whose dimensions are also becoming progressively smaller.

Heat is one problem when using the devices, especially when charging the battery. The intensive use usually drains the battery faster and users wish to charge the battery fast. For mobile devices charging times down to few minutes are desired. The generated heat usually heats the entire device to a level that is not acceptable by the users.

Fast charging means high currents. Even small resistive losses in the charging path may create high power loss. The resistive loss may be found in the battery and/or charging regulator. However, some types of batteries, such as Li-poly or Li-ion batteries actually do not generate any substantial amount of heat but heat is generated in the charging circuitry.

To ensure that the usability period nevertheless remains relatively long, however, high energy densities are needed therefore. In many cases, however, this elevated energy density causes the danger of overheating of the batteries if adequate ventilation thereof is not assured. This situation is analogously comparable with the elevated operating temperature that can develop, for example, in the internal combustion engine of an overloaded motor vehicle that is not adequately cooled. For example, the occurrence of battery temperatures of up to 600° C. has already been detected in tests with mobile telephones. This aspect represents a considerable safety risk for mobile telephone users, however, since overheated mobile telephones can catch fire or even explode. Users have already been injured on many occasions due to incidents in which mobile telephones have overheated or even exploded. In particular, not only have body burns requiring medical treatment occurred, but also property damage has been suffered.

US 2009/256523 relates to a charger connector for rechargeable vehicles comprising a fan for supplying air-conditioned air to the charging electronics.

Recently very small fans or pumps have been developed using MEMS (microelectromechanical systems) technology. The MEMS fans may use piezoelectric material as actuator. With sizes, e.g. up to 1 mm thick and 6-12 mm in diameter, MEMS fans and/or pumps give a great advantage.

MEMS fans/pumps have usually been used for integrated circuit heat dissipation attached directly on or inside, for example, microprocessors or other heat generating components.

### SUMMARY

One object of the invention is to improve the protection against overheated operating temperatures of electrical devices. Another object of the invention is to improve airflow and thus decrease heating by removing heat specially when charging a battery of an electrical device.

For these reasons, an electrical connector comprising a housing is provided. The connector comprises an arrangement configured to displace a temperature controlling medium and at least one opening in said housing for transporting said temperature controlling medium displaced by said arrangement through said opening. The arrangement is microelectromechanical systems, MEMS, arrangement, a piezoelectric arrangement or a combination thereof. The arrangement may be one or several of a fan or a pump. The connector may further comprise at least one opening functioning as intake for said medium.

According to one embodiment, the connector may be connected to a charger. The connector may comprise a power feed from said charger to said arrangement. The connector may be configured to start said arrangement when a charging is started.

The connector may comprise an airtight sealing. The intakes and openings may be provided with non return valves or MEMS valves.

An example which does not for part of the invention relates to an electrical device comprising a housing and a connector for connection to a connector is featured earlier, and further comprise intakes corresponding to said openings. The electrical device may further comprise at least one outlet. The intakes and outlets are provided with non return valves or MEMS valves. The electrical device may comprise a temperature sensor for actuating said arrangement. The electrical device may be one of a radiotelephone, a camera, a sound recorder, a global positioning system (GPS) receiver; a personal communications system (PCS) terminal, a cellular radiotelephone, a personal digital assistant (PDA) or a laptop.

### BRIEF DESCRIPTION OF THE DRAWINGS

The foregoing will be apparent from the following more particular description of the example embodiments, as illustrated in the accompanying drawings in which the like reference characters refer to the same parts throughout the different views. The drawings are not necessarily to scale, emphasis instead being placed upon illustrating the example embodiments.
- Fig. 1: illustrates a perspective view of connector according to the invention,
- Fig. 2: illustrates schematically a view from above and through the connector of Fig. 1
- Fig. 3: illustrates, in a schematic way, a sectional side view of a second embodiment of a connector according to the present invention,
- Fig. 4: illustrates, in a schematic way and sectional side view, the connector according to Fig. 3 connected to an electrical device,
- Fig. 5: illustrates, in a schematic way, a view through an exemplary MEMS pump, and
- Fig. 6: illustrates, in a schematic way, a side view through an exemplary MEMS/piezoelectric fan.

### DETAILED DESCRIPTION

A "device" as the term is used herein, is to be broadly interpreted to include a radiotelephone, a camera (e.g., video and/or still image camera), a sound recorder (e.g., a microphone), and/or global positioning system (GPS) receiver; a personal communications system (PCS) terminal that may combine a cellular radiotelephone with data processing; a personal digital assistant (PDA); a laptop; and any other electrical device with need for temperature control, especially cooling electrical components.

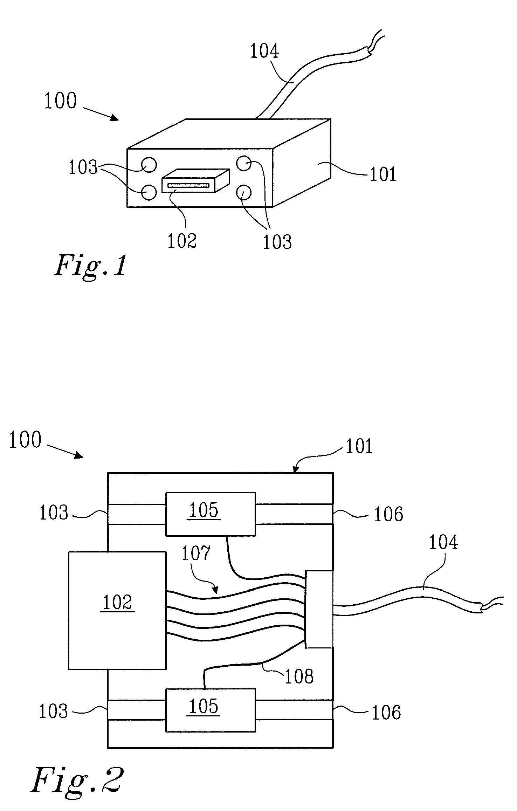

Fig. 1 is a perspective view of a connector 100 for an electrical device such as a mobile terminal, e.g. a mobile phone. The connector 100 comprises a housing 101, a connection portion 102, a number of apertures 103 and a cord 104. The cord connects the connector to a power and/or data supply (not shown). In case of power supply, it may for example be a power adapter for adapting high voltage AC to DC suitable for operating or charging the batteries of the electrical device.

Fig. 2 is a cut through the connector 100 of Fig. 1. According to this embodiment, the connector 100 comprises four MEMS pumps or fans 105 (only two illustrated in this view) provided with an intake 106 and an outlet 103.

The connector 100 further comprises wires 107 for supplying power to the device and wires 108 for supplying power to the fans or pumps. Other wires may be used for data communication, e.g. if the cord is a USB cable.

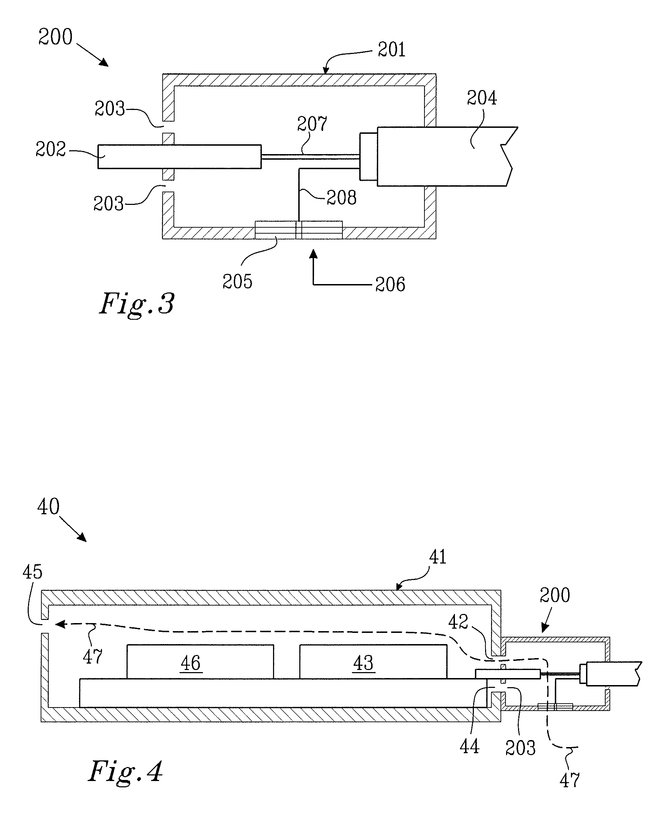

Fig. 3 is a side view through a second exemplary embodiment of a connector 200, comprising a housing 201, connecting part 202, outlets 203, cord 204, MEMS fan 205, including intake 206, power wire 207 and power supply wire 208. In this case the fan 205 may comprise a piezoelectric MEMS fan having a piezoelectric fan blade, which moves when applied an electrical current in a direction that sucks in air and blows the air into the housing 201.

Fig. 4 illustrates in a schematic way the connector 200 according to Fig. 3 connected to an electrical device 40. The electrical device comprises a housing 41 having a connector portion 42 for connection to connector 200, e.g. for charging a battery 43 of the device 40.

The device 40 at the connector portion 42 comprises intakes 44 corresponding to the outlets 203 of the connector 200. The device may also be provided with one or several outlets 45.

According to one embodiment, when charging, especially fast charging the battery 43 of the device 40, the battery 43 and other components 46, such as charging regulator components may generate heat. To dissipate heat, the MEMS fan 205 is actuated to operate by sucking in air and blowing it through outlets 203 and inlets 44 into the device housing. The air path is illustrated with dashed line 47. The air flow around the battery and components will dissipate the heat from the components out through the outlet 45 and cool down the battery 43 and components 46.

In one embodiment, the fan or pump may start when a fast charging begins and can be stopped when the device temperature is down at a normal level or when the charging is terminated. This means that temperature sensors may be incorporated in the device. These may also comprise of MEMS sensors.

Preferably, the fan is powered from the charger side when (fast) charging of the battery starts, but the fan may likewise be controlled from the device side through the connector.

The intakes on the device connector and external connector can be configured in several different ways: around the connectors, side by side to the connectors or inside thru the connectors.

Having air channels inside the connector may make it possible to provide a compact solution. The air channels can be smaller so a higher air pressure may be needed. This solution can also give an EMC screening of the air channels as the ordinary shielding of the connector will be a part of the air channels.

The air inlets and outlets may be provided with non return valves or MEMS valves to prevent moisture and dirt to enter the device/connector housing.

The connector may be provided with an airtight seal towards the device.

The fan and pump can have different embodiments to suite the mechanical properties of different connectors. Several fans can of course be used to increase performance and / or use the available space around the connector in the best way.

Due to the mounting of the fan or pump in the external charging connector no additional space penalties or additional power consumption will affect the mobile device.

The MEMS fan or pump may also be used to transport heat into the device, e.g. if the device is used in a cold environment.

In the above examples, air is used as temperature control medium. However, other mediums such as other gases or liquids may also be used. In case of liquids, special closed channels for transporting the liquid medium can be implemented. The liquid medium may be used in devices with high heat generation.

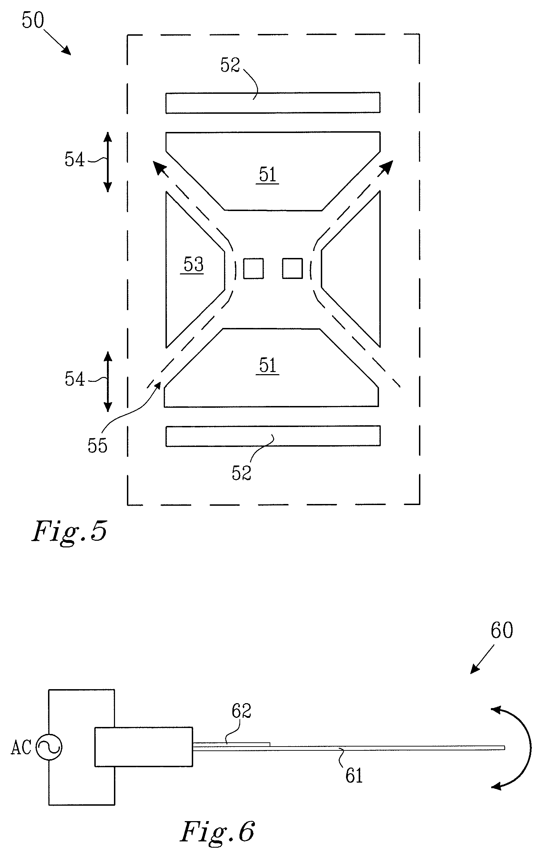

Fig. 5 illustrates a sectional view of an exemplary MEMS pump 50 comprising compression diaphragms 51, cap plates 52, and guide walls 53. By applying a suitable alternating current, compression diaphragms 51 are move in the direction of arrows 54 and displace a medium through channels 55.

Fig. 6 illustrates a schematic piezoelectric fan 60. The piezoelectric fan has a flexible blade 61, e.g. made of mylar, that is set into motion by a piezoceramic bending element 62. This bending element functions due to an ultra low power oscillating current of electricity. The electric field causes the piezoceramic to elongate, which bends the blade back and forth. The rapid flapping action produced creates air flow and cooling capacity.

The term electrical connector as used herein may be defined broadly to include data connectors, modular connectors, component and device connectors, plug and socket connectors, etc.

It should be noted that the word "comprising" does not exclude the presence of other elements or steps than those listed and the words "a" or "an" preceding an element do not exclude the presence of a plurality of such elements. It should further be noted that any reference signs do not limit the scope of the claims, that the invention may be implemented at least in part by means of both hardware and software, and that several "means", "units" or "devices" may be represented by the same item of hardware.

The foregoing description of embodiments of the present invention, have been presented for purposes of illustration and description. The foregoing description is not intended to be exhaustive or to limit embodiments of the present invention to the precise form disclosed, within the scope of the appended claims and modifications and variations are possible in light of the above teachings.

The embodiments discussed herein were chosen and described in order to explain the principles and the nature of various embodiments of the present invention and its practical application to enable one skilled in the art to utilize the present invention in various embodiments and with various modifications as are suited to the particular use contemplated.

## Claims

1. An electrical connector (100, 200) for connecting an electrical power to an electrical device (40), the electrical connector comprising a housing (101, 201), an arrangement (105, 205) configured to displace a temperature controlling medium and at least one outlet opening (103, 203) in said housing (101, 201) for transporting said temperature controlling medium displaced by said arrangement (105, 205) through said opening (103, 203) ***characterised in* that** the arrangement (105, 205) configured to displace the temperature controlling medium comprises a microelectromechanical systems (MEMS) arrangement, a piezoelectric arrangement or a combination thereof.

2. The connector of claim 1, wherein said arrangement is one or several of a fan (60, 205) or a pump (50, 105).

3. The connector according to any of claims 1 or 2, further comprising at least one opening (106, 206) functioning as intake for said medium.

4. The connector according to any of claims 1 -3, connectable to a charger.

5. The connector of claim 4, comprising a power feed from said charger to said arrangement.

6. The connector according to claim 4, configured to start said arrangement when a charging is started.

7. The connector according to any of preceding claims, comprising an airtight sealing.

8. The connector according to any of preceding claims, wherein said intakes and openings are provided with non-return valves or MEMS valves.

## Patentansprüche

1. Elektrischer Stecker (100, 200) zum Verbinden eines elektrischen Signals und/oder von elektrischem Strom mit einem Elektrogerät (40), wobei der elektrische Stecker ein Gehäuse (101, 201), eine Anordnung (105, 205), die zum Verdrängen eines Temperatursteuerungsmediums konfiguriert ist, und mindestens eine Auslassöffnung (103, 203) in dem Gehäuse (101, 201) umfasst, um das durch die Anordnung (105, 205) verdrängte Temperatursteuerungsmedium durch die Öffnung (103, 203) zu transportieren, ***dadurch gekennzeichnet,* dass** die zum Verdrängen des Temperatursteuerungsmediums konfigurierte Anordnung (105, 205) eine mikroelektromechanische System (MEMS)-Anordnung, eine piezoelektrische Anordnung oder eine Kombination davon umfasst.

2. Stecker nach Anspruch 1, wobei die Anordnung eines oder mehrere von einem Ventilator (60, 205) oder einer Pumpe (50, 105) ist.

3. Stecker nach einem der Ansprüche 1 oder 2, ferner umfassend mindestens eine Öffnung (106, 206), die als Zulauf für das Medium agiert.

4. Stecker nach einem der Ansprüche 1 - 3, der mit einem Ladegerät verbunden werden kann.

5. Stecker nach Anspruch 4, umfassend eine Stromzuführung von dem Ladegerät zu der Anordnung.

6. Stecker nach Anspruch 4, der zum Starten der Anordnung konfiguriert ist, wenn ein Ladevorgang gestartet wird.

7. Stecker nach einem der vorhergehenden Ansprüche, umfassend eine luftdichte Versiegelung.

8. Stecker nach einem der vorhergehenden Ansprüche, wobei die Zuläufe und Öffnungen mit Rückschlagventilen oder MEMS-Ventilen ausgestattet sind.

## Revendications

1. Connecteur électrique (100, 200) pour connecter un signal électrique et/ou une puissance électrique à un dispositif électrique (40), le connecteur électrique comprenant un logement (101, 201), un dispositif (105, 205) configuré pour déplacer un milieu de contrôle de température et au moins une ouverture de sortie (103, 203) dans ledit logement (101, 201) pour transporter ledit milieu de contrôle de température déplacé par ledit dispositif (105, 205) à travers ladite ouverture (103, 203), **caractérisé en ce que** le dispositif (105, 205) configuré pour déplacer le milieu de contrôle de température comprend un agencement de système microélectromécanique (MEMS), un agencement piézoélectrique ou une combinaison de ces derniers.

2. Connecteur selon la revendication 1, dans lequel ledit agencement est un ou plusieurs d'un ventilateur (60, 205) ou une pompe (50, 105).

3. Connecteur selon une quelconque des revendications 1 ou 2, comprenant en outre au moins une ouverture (106, 206) fonctionnant comme admission pour ledit milieu.

4. Connecteur selon une quelconque des revendications 1 - 3, connectable à un chargeur.

5. Connecteur selon la revendication 4, comprenant une alimentation électrique à partir dudit chargeur vers ledit agencement.

6. Connecteur selon la revendication 4, configuré pour démarrer ledit agencement quand une charge est démarrée.

7. Connecteur selon une quelconque des revendications précédentes, comprenant un scellage étanche à l'air.

8. Connecteur selon une quelconque des revendications précédentes, dans lequel lesdites admissions et ouvertures sont pourvues de clapets anti-retour ou valves MEMS.
